# EUROPEAN PATENT APPLICATION

(11) **EP 4 715 818 A1**
(43) Date of publication of application: **25.03.2026**
(21) Application number: 24939430.5
(22) Date of filing: 28.10.2024
(51) Int. Cl.: G11C 7/22

(54) **CLOCK CONTROL CIRCUIT, MEMORY AND CLOCK CONTROL METHOD**

(30) Priority: 21.05.2024 CN 202410651361
(71) Applicant: CXMT Corporation, Hefei City, Anhui Province 230601 (CN)
(72) Inventor: ZHANG, Zhiqiang, Hefei, Anhui 230601 (CN)
(74) Representative: Gulde & Partner
(86) International application number: PCT/CN2024/127587
(87) International publication number: WO 2025/241416

(57) **Abstract**

Embodiments of the present disclosure provide a clock control circuit, a memory, and a clock control method, where the clock control circuit includes: a delay adjustment circuit, configured to receive a first phase clock signal, a second phase clock signal, a third phase clock signal, a fourth phase clock signal, and a determination result signal, and adjust delays of the second phase clock signal, the third phase clock signal, and the fourth phase clock signal or adjust delays of the first phase clock signal, the second phase clock signal, and the fourth phase clock signal according to the determination result signal in a duty cycle adjustment training mode; and a determination circuit, configured to record a phase sequence of the first phase clock signal and the third phase clock signal at self-refresh exit timing, then compare the phase sequence of the first phase clock signal and the third phase clock signal at the self-refresh exit timing with a phase sequence of the first phase clock signal and the third phase clock signal at previous self-refresh exit timing, and output the determination result signal according to whether the two phase sequences are consistent or not. The disclosed embodiments are advantageous for at least improving the phase differences between the four-phase clock signals.

## Description

### CROSS-REFERENCE TO RELATED APPLICATIONS

The present application claims priority to Chinese Patent Application No. 202410651361.6 filed with China National Intellectual Property Administration on May 21, 2024, and entitled "CLOCK CONTROL CIRCUIT, MEMORY, AND CLOCK CONTROL METHOD", the content of which is incorporated herein by reference in its entirety.

### TECHNICAL FIELD

Embodiments of the present disclosure relate to the technical field of semiconductors, and in particular, to a clock control circuit, a memory, and a clock control method.

### BACKGROUND

A clock is a very important component of a digital circuit and provides a stable time reference such that various parts of the digital circuit can operate based on a predetermined time sequence.

In memory, the clock also plays a very important role. Data in the memory is usually transmitted in a certain time sequence. A clock signal is capable of controlling the input and output of data, ensuring that data is read or written at the correct point in time. Through the synchronous action of the clock, the memory can coordinate with other digital circuit components, so as to ensure the accuracy and the reliability of data transmission. However, due to environmental influences, the external clock signal received by the memory may have a duty cycle variation, which may affect the normal operation of the internal clock of the memory.

### SUMMARY

Embodiments of the present disclosure provide a clock control circuit, a memory, and a clock control method, which are at least beneficial for improving a phase difference between four-phase clock signals.

In a first aspect, the embodiments of the present disclosure provide a clock control circuit, which is applied to a memory, and includes:
a delay adjustment circuit, configured to receive a first phase clock signal, a second phase clock signal, a third phase clock signal, a fourth phase clock signal, and a determination result signal, adjust delays of the second phase clock signal, the third phase clock signal, and the fourth phase clock signal or adjust delays of the first phase clock signal, the second phase clock signal, and the fourth phase clock signal according to the determination result signal when the memory is in a duty cycle adjustment training mode, and output a first target clock signal, a second target clock signal, a third target clock signal, and a fourth target clock signal; and
a determination circuit, electrically connected with the delay adjustment circuit, and configured to record a phase sequence of the first phase clock signal and the third phase clock signal at self-refresh exit timing of the memory, then compare the phase sequence of the first phase clock signal and the third phase clock signal at the self-refresh exit timing with a phase sequence of the first phase clock signal and the third phase clock signal at previous self-refresh exit timing, and output the determination result signal according to whether the two phase sequences are consistent or not.

In some embodiments, recording the phase sequence of the first phase clock signal and the third phase clock signal at the self-refresh exit timing of the memory includes: receiving, by the memory, a no-operation NOP command at the self-refresh exit timing, and if the no-operation NOP command is sampled at a rising edge of the first phase clock signal, recording that the first phase clock signal leads the third phase clock signal in phase; and if the no-operation NOP command is sampled at a rising edge of the third phase clock signal, recording that the first phase clock signal lags the third phase clock signal in phase; and comparing the phase sequence of the first phase clock signal and the third phase clock signal at the self-refresh exit timing with the phase sequence of the first phase clock signal and the third phase clock signal at the previous self-refresh exit timing, and outputting the determination result signal according to whether the two phase sequences are consistent or not include: outputting the determination result signal with a logic value of 1 if the two phase sequences are consistent, and outputting the determination result signal with the logic value of 0 if the two phase sequences are inconsistent.

In some embodiments, the delay adjustment circuit includes: a control circuit, configured to receive a first set of control codes, a second set of control codes, and the determination result signal, output the first set of control codes as target control codes if the logic value of the determination result signal is 1, and output the second set of control codes as the target control codes if the logic value of the determination result signal is 0; where the first set of control codes is used for adjusting the delays of the second phase clock signal, the third phase clock signal, and the fourth phase clock signal, and the second set of control codes is used for adjusting the delays of the first phase clock signal, the second phase clock signal, and the fourth phase clock signal; and a delay circuit, electrically connected with the control circuit, and configured to receive the first phase clock signal, the second phase clock signal, the third phase clock signal, the fourth phase clock signal and the target control codes, adjust the delays of the second phase clock signal, the third phase clock signal, and the fourth phase clock signal or adjust the delays of the first phase clock signal, the second phase clock signal, and the fourth phase clock signal according to the target control codes, and output the first target clock signal, the second target clock signal, the third target clock signal, and the fourth target clock signal.

In some embodiments, the target control codes include a first target control code, a second target control code, a third target control code, and a fourth target control code, and the delay circuit includes: a first delay sub-circuit, configured to receive the first phase clock signal and the first target control code, adjust the delay of the first phase clock signal according to the first target control code, and output the first target clock signal; a second delay sub-circuit, configured to receive the second phase clock signal and the second target control code, adjust the delay of the second phase clock signal according to the second target control code, and output the second target clock signal; a third delay sub-circuit, configured to receive the third phase clock signal and the third target control code, adjust the delay of the third phase clock signal according to the third target control code, and output the third target clock signal; and a fourth delay sub-circuit, configured to receive the fourth phase clock signal and the fourth target control code, adjust the delay of the fourth phase clock signal according to the fourth target control code, and output the fourth target clock signal.

In some embodiments, the first set of control codes sequentially includes a ground signal, a second phase control code, a third phase control code, and a fourth phase control code; the second set of control codes sequentially includes the third phase control code, the fourth phase control code, the ground signal, and the second phase control code; and the control circuit includes: a first selection unit, configured to receive the ground signal, the third phase control code, and the determination result signal, output the ground signal as the first target control code if the logic value of the determination result signal is 1, and output the third phase control code as the first target control code if the logic value of the determination result signal is 0; a second selection unit, configured to receive the second phase control code, the fourth phase control code, and the determination result signal, output the second phase control code as the second target control code if the logic value of the determination result signal is 1, and output the fourth phase control code as the second target control code if the logic value of the determination result signal is 0; a third selection unit, configured to receive the third phase control code, the ground signal, and the determination result signal, output the third phase control code as the third target control code if the logic value of the determination result signal is 1, and output the ground signal as the third target control code if the logic value of the determination result signal is 0; and a fourth selection unit, configured to receive the fourth phase control code, the second phase control code, and the determination result signal, output the fourth phase control code as the fourth target control code if the logic value of the determination result signal is 1, and output the second phase control code as the fourth target control code if the logic value of the determination result signal is 0.

In some embodiments, the second phase control code, the third phase control code, and the fourth phase control code are stored and output by a mode register.

In some embodiments, the first delay sub-circuit includes a first capacitor unit and an even number of first inverters, where the even number of first inverters are sequentially connected, an input terminal of a first inverter at a head receives the first phase clock signal, an output terminal of a first inverter at a tail outputs the first target clock signal, and the first capacitor unit receives the first target control code and is connected to an output terminal of one of the first inverters; the second delay sub-circuit includes a second capacitor unit and an even number of second inverters, where the even number of second inverters are sequentially connected, an input terminal of a second inverter at a head receives the second phase clock signal, an output terminal of a second inverter at a tail outputs the second target clock signal, and the second capacitor unit receives the second target control code and is connected to an output terminal of one of the second inverters; the third delay sub-circuit includes a third capacitor unit and an even number of third inverters, where the even number of third inverters are sequentially connected, an input terminal of a third inverter at a head receives the third phase clock signal, an output terminal of a third inverter at a tail outputs the third target clock signal, and the third capacitor unit receives the third target control code and is connected to an output terminal of one of the third inverters; and the fourth delay sub-circuit includes a fourth capacitor unit and an even number of fourth inverters, where the even number of fourth inverters are sequentially connected, an input terminal of a fourth inverter at a head receives the fourth phase clock signal, an output terminal of a fourth inverter at a tail outputs the fourth target clock signal, and the fourth capacitor unit receives the fourth target control code and is connected to an output terminal of one of the fourth inverters.

In some embodiments, the determination circuit includes: a latch, configured to receive a first mark signal and a second mark signal, where the first mark signal is used for indicating that the no-operation NOP command is sampled at the rising edge of the first phase clock signal at the self-refresh exit timing, the second mark signal is used for indicating that the no-operation NOP command is sampled at the rising edge of the third phase clock signal at the self-refresh exit timing, and output a phase flag signal at a first level if the first mark signal is in a valid state and output the phase flag signal at a second level if the second mark signal is in the valid state; and a comparison unit, electrically connected with the latch, and configured to receive and store the phase flag signal, compare a level state of the phase flag signal received at current self-refresh exit timing with a level state of the phase flag signal received at previous self-refresh exit timing, output the determination result signal with the logic value of 1 if the two level states are consistent, and output the determination result signal with the logic value of 0 if the two level states are inconsistent.

In some embodiments, the latch is an SR latch, where a first terminal of the SR latch receives the first mark signal, a second terminal receives the second mark signal, and an output terminal outputs the phase flag signal.

In a second aspect, the embodiments of the present disclosure provide a memory. The memory includes at least the clock control circuit as described in the first aspect.

In some embodiments, the memory further includes: a receiving circuit, configured to receive an external clock signal and output an internal clock signal, the internal clock signal having a same frequency as the external clock signal; a frequency divider, electrically connected with the receiving circuit, and configured to receive the internal clock signal, divide the internal clock signal by two, and generate the first phase clock signal, the second phase clock signal, the third phase clock signal, and the fourth phase clock signal; and a delay lock loop, electrically connected with the frequency divider and the clock control circuit, and configured to delay at least one of the first phase clock signal, the second phase clock signal, the third phase clock signal, and the fourth phase clock signal such that at least one of the first phase clock signal, the second phase clock signal, the third phase clock signal, and the fourth phase clock signal has a phase difference with the external clock signal that is less than a preset value.

In some embodiments, the memory conforms to DDR5 specification.

In a third aspect, the embodiments of the present disclosure provide a clock control method, which is applied to a memory, and includes: recording a phase sequence of a first phase clock signal and a third phase clock signal at self-refresh exit timing of the memory, and comparing the phase sequence of the first phase clock signal and the third phase clock signal at the self-refresh exit timing with a phase sequence of the first phase clock signal and the third phase clock signal at previous self-refresh exit timing, so as to determine whether the two phase sequences are consistent or not; and adjusting, if the two phase sequences are consistent, delays of a second phase clock signal, the third phase clock signal, and a fourth phase clock signal when the memory is in a duty cycle adjustment training mode; and adjusting, if the two phase sequences are not consistent, delays of the first phase clock signal, the second phase clock signal, and the fourth phase clock signal when the memory is in the duty cycle adjustment training mode.

In some embodiments, recording the phase sequence of the first phase clock signal and the third phase clock signal at the self-refresh exit timing of the memory includes: receiving, by the memory, a no-operation NOP command at the self-refresh exit timing, and if the no-operation NOP command is sampled at a rising edge of the first phase clock signal, recording that the first phase clock signal leads the third phase clock signal in phase; and if the no-operation NOP command is sampled at a rising edge of the third phase clock signal, recording that the first phase clock signal lags the third phase clock signal in phase.

In some embodiments, adjusting, if the two phase sequences are consistent, the delays of the second phase clock signal, the third phase clock signal, and the fourth phase clock signal when the memory is in the duty cycle adjustment training mode; and adjusting, if the two phase sequences are not consistent, the delays of the first phase clock signal, the second phase clock signal, and the fourth phase clock signal when the memory is in the duty cycle adjustment training mode include: adjusting, if the two phase sequences are consistent, the delays of the second phase clock signal, the third phase clock signal, and the fourth phase clock signal by using a first set of control codes when the memory is in the duty cycle adjustment training mode; and adjusting, if the two phase sequences are not consistent, the delays of the first phase clock signal, the second phase clock signal, and the fourth phase clock signal by using a second set of control codes when the memory is in the duty cycle adjustment training mode.

The technical solutions according to the embodiments of the present disclosure at least have the following advantages:
Provided is a clock control circuit, which is applied to a memory and includes: a delay adjustment circuit, configured to receive a first phase clock signal, a second phase clock signal, a third phase clock signal, a fourth phase clock signal, and a determination result signal, adjust delays of the second phase clock signal, the third phase clock signal, and the fourth phase clock signal or adjust delays of the first phase clock signal, the second phase clock signal, and the fourth phase clock signal according to the determination result signal when the memory is in a duty cycle adjustment training mode, and output a first target clock signal, a second target clock signal, a third target clock signal, and a fourth target clock signal; and a determination circuit, electrically connected with the delay adjustment circuit, and configured to record a phase sequence of the first phase clock signal and the third phase clock signal at self-refresh exit timing, then compare the phase sequence of the first phase clock signal and the third phase clock signal at the self-refresh exit timing with a phase sequence of the first phase clock signal and the third phase clock signal at previous self-refresh exit timing, and output the determination result signal according to whether the two phase sequences are consistent or not. When the memory is in the self-refresh mode, an external clock signal is not received, and when the memory exits the self-refresh mode, the external clock signal is received again, and at the moment, duty cycle adjust training needs to be carried out to adjust the phase difference between the internal four-phase clock signals. The phase sequence of the first phase clock signal and the third phase clock signal at the current self-refresh exit timing and the phase sequence of the first phase clock signal and the third phase clock signal at the previous self-refresh exit timing are recorded and compared, and the delays of the second phase clock signal, the third phase clock signal, and the fourth phase clock signal or the delays of the first phase clock signal, the second phase clock signal, and the fourth phase clock signal are adjusted according to whether the two phase sequences are consistent or not, which is favorable for adjusting the phase differences between the four-phase clock signals more accurately and more quickly in a duty cycle adjustment training mode, saving the time of duty cycle adjust training, improving the accuracy of the four-phase clock signals, and ensuring the quality of final output data of the memory.

### BRIEF DESCRIPTION OF DRAWINGS

One or more embodiments are illustrated by figures in the corresponding drawings. These exemplary explanations do not constitute limitations on the embodiments, and elements with identical reference numerals in the drawings represent similar elements. Unless expressly stated otherwise, the figures in the drawings do not constitute a proportion limitation. To more clearly illustrate the technical solutions in the embodiments of the present disclosure or the conventional technology, a brief introduction to the drawings required for the description of the embodiments is given hereinafter. It is evident that the drawings described hereinafter are merely some embodiments of the present disclosure. For those of ordinary skill in the art, other drawings may also be obtained based on these drawings without creative effort.
FIG. 1 is a flowchart illustrating the operation of a memory according to an embodiment of the present disclosure;
FIG. 2a is a waveform diagram of clock signals in a memory in one scenario according to an embodiment of the present disclosure;
FIG. 2b is a waveform diagram of clock signals in a memory in another scenario according to an embodiment of the present disclosure;
FIG. 2c is a waveform diagram of clock signals in a memory in yet another scenario according to an embodiment of the present disclosure;
FIG. 3 is a schematic structural diagram of a clock control circuit according to an embodiment of the present disclosure;
FIG. 4 is a schematic structural diagram of a delay adjustment circuit according to an embodiment of the present disclosure;
FIG. 5 is a schematic structural diagram of a delay circuit according to an embodiment of the present disclosure;
FIG. 6 is a schematic structural diagram of a control circuit according to an embodiment of the present disclosure;
FIG. 7 is a schematic structural diagram of a first delay sub-circuit according to an embodiment of the present disclosure;
FIG. 8 is a schematic structural diagram of a determination circuit according to an embodiment of the present disclosure;
FIG. 9 is a schematic structural diagram of a memory according to an embodiment of the present disclosure;
FIG. 10 is another schematic structural diagram of the memory according to an embodiment of the present disclosure; and
FIG. 11 is a schematic flowchart of a clock control method according to an embodiment of the present disclosure.

### DESCRIPTION OF EMBODIMENTS

The technical solutions in embodiments of the present disclosure will be clearly and completely described below with reference to the drawings in the embodiments of the present disclosure. It can be understood that the specific embodiments described herein are merely illustrative of a related application and are not intended to limit the present application. In addition, it should be noted that for the convenience of description, only the portions relevant to the related applications are shown in the drawings. Unless otherwise defined, all technical and scientific terms used herein have the same meaning as commonly understood by those skilled in the art to which the present disclosure belongs. The terms used herein are for the purpose of describing the embodiments of the present disclosure only and are not intended to limit the present disclosure. In the following description, reference is made to "some embodiments" which describe subsets of all possible embodiments, but it can be understood that "some embodiments" may be the same subset or different subsets of all possible embodiments, and may be combined with each other without conflict. It should be noted that the terms "first\second\third" referred to in the embodiments of the present disclosure are merely used to distinguish similar objects and do not represent a specific ordering for the objects. It can be understood that "first\second\third" may be subjected to interchange of a specific order or sequence if permitted, such that the embodiments of the present disclosure described herein can be implemented in an order other than that shown or described herein.
Dynamic Random Access Memory (DRAM)
Synchronous Dynamic Random Access Memory (SDRAM)
Double Data Rate SDRAM (DDR SDRAM)
Low Power DDR (LPDDR)
DDRn Specification, e.g., DDR3, DDR4, DDR5, or DDR6
LPDDRn Specification, e.g., LPDDR3, LPDDR4, LPDDR5, or LPDDR6
Self-Refresh Exit (SRX) Command
No-Operation (NOP) Command
Duty Cycle Adjust Training (DCA Training)

A clock is a very important component of a digital circuit and provides a stable time reference such that various parts of the digital circuit can operate based on a predetermined time sequence. In memory, the clock also plays a very important role. Data in the memory is usually transmitted in a certain time sequence. A clock signal is capable of controlling the input and output of data, ensuring that data is read or written at the correct point in time. Through the synchronous action of the clock, the memory can coordinate with other digital circuit components, so as to ensure the accuracy and the reliability of data transmission.

As the operating frequency of the memory is faster and faster, the frequency of the received external clock signal is higher and higher, and therefore, the frequency division needs to be performed inside the memory to generate internal multi-phase clock signals for data processing. The phase difference between the multi-phase clock signals is related to the quality of the final output data of the memory. When the duty cycle of the external clock signal changes, the phase difference between the internal divided multi-phase clock signals also changes, which causes the signal quality of the output data of the memory to decrease, so the duty cycle adjust training (DCA training) is required to adjust the phase difference between the internal multi-phase clock signals. However, the applicant has found that in some cases, after the DCA training, the phase difference between the multi-phase clock signals in the memory becomes larger, or it takes a lot of time to complete the adjustment of the phase difference. The applicant has analytically found that this is related to the sequence of the multi-phase clock signals each time the memory exits the self-refresh mode.

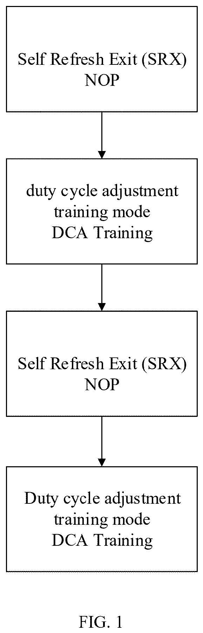

Taking DDR5 DRAM as an example, in order to achieve high-frequency operation of a memory, four-phase clock signals are generated inside the memory based on an external clock signal for data processing. Ideally, the four-phase clock signals include four clock signals with successive 90-degree phase shifts. However, in a high-frequency environment, when the duty cycle of the external clock signal changes, the phase difference between the internal four-phase clock signals also changes. Therefore, the DDR5 specification specifies that the DCA training needs to be performed at high frequencies to adjust the phase difference between the internal four-phase clock signals. The delays of the four-phase clock signals may be set by a mode register to adjust the phase difference therebetween. Referring to FIG. 1, a flowchart illustrating the operation of a memory in one scenario is illustrated. When the memory is in the self-refresh mode, the external clock signal is not received, the four-phase clock signals are not generated inside, and when the memory exits the self-refresh mode, the external clock signal is received again, the four-phase clock signals are generated, and at the moment, the DCA training is required to be carried out to adjust the phase difference between the internal four-phase clock signals. The memory exits the self-refresh mode in response to a self-refresh exit (SRX) command, and then receives a no-operation (NOP) command. That is, the memory, when exiting the self-refresh mode, may receive the SRX and NOP commands in sequence.

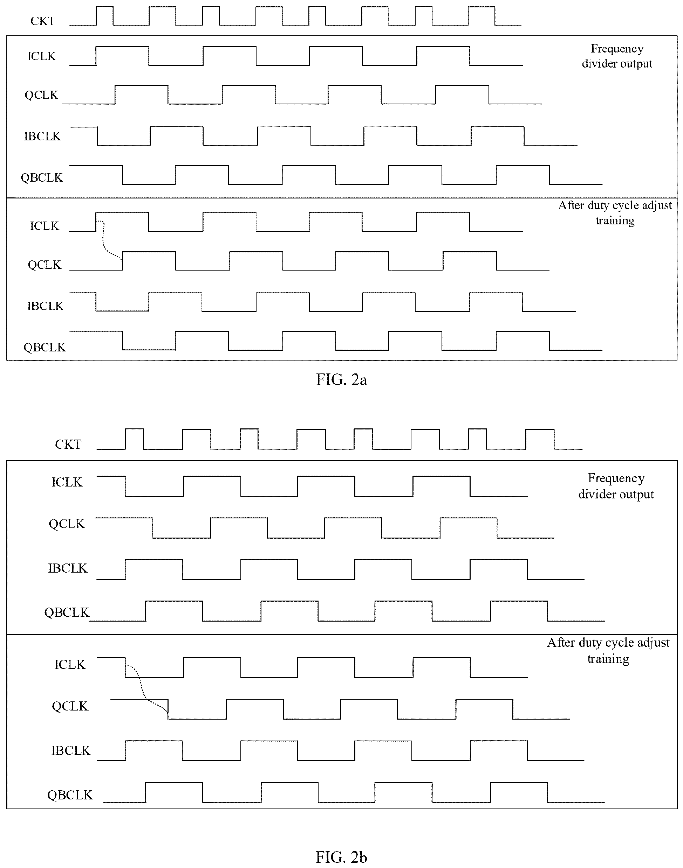

Referring to FIG. 2a, it corresponds to a waveform diagram in the first SRX and the DCA training mode in FIG. 1. As shown in FIG. 2a, the duty cycle of an external clock signal CKT received by the memory is unstable, and the phase differences between four-phase clock signals output by a frequency divider deviate significantly from the ideal 90-degree spacing. The four-phase clock signals include a first phase clock signal ICLK, a second phase clock signal QCLK, a third phase clock signal IBCLK, and a fourth phase clock signal QBCLK. Ideally, ICLK, QCLK, IBCLK, and QBCLK should have successive 90-degree phase shifts, but the phase differences between the four-phase clock signals output by the frequency divider are not 90 degrees. In the DCA training mode, the delays of the second phase clock signal QCLK, the third phase clock signal IBCLK, and the fourth phase clock signal QBCLK are adjusted by setting parameters of a mode register to adjust the phase differences between the internal four-phase clock signals, such that the difference between each of the phase differences and 90 degrees is less than a preset value, i.e., the phase differences between the internal four-phase clock signals approach 90 degrees. In this process, the delay of the first phase clock signal ICLK is fixed, i.e., the delay of ICLK is not adjusted.

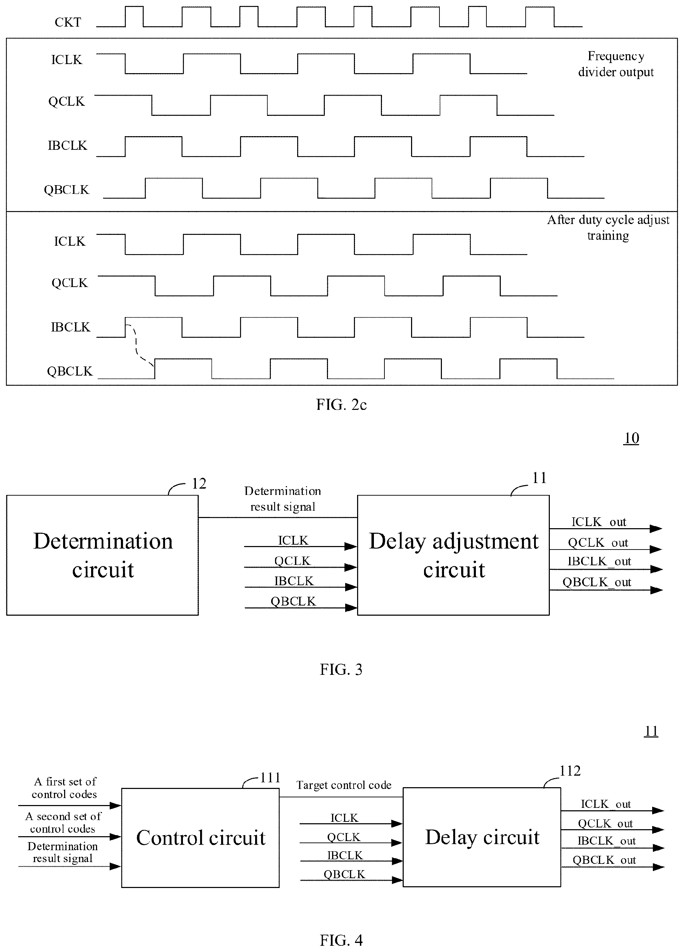

Referring to FIG. 2b, it corresponds to a waveform diagram in the second SRX and the DCA training mode in FIG. 1. As shown in FIG. 2b, at the second SRX timing, the sequence of the four-phase clock signals generated by the frequency divider is inconsistent with the sequence at the first SRX timing. At the first SRX timing, ICLK, QCLK, IBCLK, and QBCLK are sequentially generated, such that a rising edge of ICLK is generated synchronously with the first rising edge of an external clock signal CKT received at the SRX timing. And at the second SRX timing, IBCLK, QBCLK, ICLK, and QCLK are generated in sequence, and a rising edge of IBCLK is generated synchronously with the first rising edge of the external clock signal CKT received at the SRX timing. At this time, adjusting the delays of the second phase clock signal QCLK, the third phase clock signal IBCLK, and the fourth phase clock signal QBCLK by using the above parameters set in the mode register in the last DCA training mode may degrade the phase differences between the four-phase clock signals. Since the parameters stored in the mode register at this time are applicable to the sequence of the four-phase clock signals at the first SRX timing. In the current DCA training mode, if the parameters set in the mode register are readjusted, a lot of time is required to enable the phase differences between the internal four-phase clock signals to reach an ideal condition. The applicant has analytically found that if the parameters set in the mode register in the last DCA training mode are required to be used, the parameters originally controlling the delay of QCLK need to be switched to control the delay of QBCLK, the parameters originally controlling the delay of QBCLK need to be switched to control the delay of QCLK, the parameters originally controlling the delay of IBCLK need to be switched to control the delay of ICLK, and meanwhile, the delay of IBCLK is fixed and is not adjusted. In this way, as shown in FIG. 2c, the phase differences between the internal four-phase clock signals can be adjusted as soon as possible such that the difference between each of the phase differences and 90 degrees is less than a preset value, i.e., the phase differences between the internal four-phase clock signals approach 90 degrees. By switching the delay control of the four-phase clock signals, under the condition that the sequence of the four-phase clock signals generated when the memory exits the self-refresh mode changes, the phase differences between the four-phase clock signals can be quickly and accurately adjusted by using the above parameters set in the mode register last time in the subsequent DCA training mode. The essence of switching the delay control of the four-phase clock signals is to fix the delay of the first clock signal generated by the frequency divider every time and adjust the delay of the next three clock signals. That is, if a rising edge of ICLK is generated synchronously with the first rising edge of the external clock signal CKT received at the SRX timing, i.e., the first clock signal generated by the frequency divider is ICLK, the delay of ICLK is fixed, and the delays of QCLK, IBCLK, and QBCLK are adjusted, and if a rising edge of IBCLK is generated synchronously with the first rising edge of the external clock signal CKT received at the SRX timing, i.e., the first clock signal generated by the frequency divider is IBCLK, the delay of IBCLK is fixed, and the delays of QBCLK, ICLK, and QCLK are adjusted.

Based on this, the embodiments of the present disclosure provide a clock control circuit, which is applied to a memory and includes: a delay adjustment circuit, configured to receive a first phase clock signal, a second phase clock signal, a third phase clock signal, a fourth phase clock signal, and a determination result signal, adjust delays of the second phase clock signal, the third phase clock signal, and the fourth phase clock signal or adjust delays of the first phase clock signal, the second phase clock signal, and the fourth phase clock signal according to the determination result signal when the memory is in a DCA training mode, and output a first target clock signal, a second target clock signal, a third target clock signal, and a fourth target clock signal; and a determination circuit, electrically connected with the delay adjustment circuit, and configured to record a phase sequence of the first phase clock signal and the third phase clock signal at SRX timing, then compare the phase sequence of the first phase clock signal and the third phase clock signal at the SRX timing with a phase sequence of the first phase clock signal and the third phase clock signal at previous SRX timing, and output the determination result signal according to whether the two phase sequences are consistent or not. When the memory is in the self-refresh mode, an external clock signal is not received, and when the memory exits the self-refresh mode, the external clock signal is received again, and at the moment, duty cycle adjust training needs to be carried out to adjust the phase difference between the internal four-phase clock signals. The phase sequence of the first phase clock signal and the third phase clock signal at the current self-refresh exit timing and the phase sequence of the first phase clock signal and the third phase clock signal at the previous self-refresh exit timing are recorded and compared, and the delays of the second phase clock signal, the third phase clock signal, and the fourth phase clock signal or the delays of the first phase clock signal, the second phase clock signal, and the fourth phase clock signal are adjusted according to whether the two phase sequences are consistent or not, which is favorable for adjusting the phase differences between the four-phase clock signals more accurately and more quickly in a duty cycle adjustment training mode, saving the time of duty cycle adjust training, improving the accuracy of the four-phase clock signals, and ensuring the quality of final output data of the memory.

The embodiments of the present disclosure are described in detail below with reference to the drawings.

In an embodiment of the present disclosure, referring to FIG. 3, a schematic structure diagram of a clock control circuit 10 according to an embodiment of the present disclosure is illustrated. As shown in FIG. 3, the clock control circuit 10 includes:
a delay adjustment circuit 11, configured to receive a first phase clock signal ICLK, a second phase clock signal QCLK, a third phase clock signal IBCLK, a fourth phase clock signal QBCLK, and a determination result signal, adjust delays of the second phase clock signal QCLK, the third phase clock signal IBCLK, and the fourth phase clock signal QBCLK or adjust delays of the first phase clock signal ICLK, the second phase clock signal QCLK, and the fourth phase clock signal QBCLK according to the determination result signal when the memory is in a DCA training mode, and output a first target clock signal ICLK_out, a second target clock signal QCLK_out, a third target clock signal IBCLK_out, and a fourth target clock signal QBCLK_out; and
a determination circuit 12, electrically connected with the delay adjustment circuit 11, and configured to record a phase sequence of the first phase clock signal ICLK and the third phase clock signal IBCLK at SRX timing of the memory, then compare the phase sequence of the first phase clock signal ICLK and the third phase clock signal IBCLK at the SRX timing with a phase sequence of the first phase clock signal ICLK and the third phase clock signal IBCLK at previous SRX timing, and output the determination result signal according to whether the two phase sequences are consistent or not.

It should be noted that the clock control circuit 10 of the embodiment of the present disclosure may be applied to a memory, such as a DRAM or an SDRAM. When the memory is in the self-refresh mode, the external clock signal is not received, the four-phase clock signals are not generated inside, and when the memory exits the self-refresh mode, the external clock signal is received again, the four-phase clock signals are generated, and at the moment, the DCA training is required to be carried out to adjust the phase difference between the internal four-phase clock signals.

The determination circuit 12 records and compares the phase sequence of the first phase clock signal ICLK and the third phase clock signal IBCLK at the current SRX timing and the phase sequence of the first phase clock signal ICLK and the third phase clock signal IBCLK at the previous SRX timing, adjusts the delays of the second phase clock signal QCLK, the third phase clock signal IBCLK, and the fourth phase clock signal QBCLK or adjusts the delays of the first phase clock signal ICLK, the second phase clock signal QCLK, and the fourth phase clock signal QBCLK through the delay adjustment circuit 11 according to whether the two phase sequences are consistent or not, and outputs the first target clock signal ICLK_out, the second target clock signal QCLK_out, the third target clock signal IBCLK_out, and the fourth target clock signal QBCLK_out. Therefore, the phase differences between the four-phase clock signals can be adjusted more accurately and more quickly in the DCA training mode, such that the output first target clock signal ICLK_out, the output second target clock signal QCLK_out, the output third target clock signal IBCLK_out, and the output fourth target clock signal QBCLK_out have successive 90-degree phase shifts. The DCA training time is saved, the accuracy of the four-phase clock signals is improved, and the quality of the final output data of the memory is ensured.

It should be understood that the embodiments of the present disclosure allow a certain error in the definition of phase differences. That is, the first target clock signal, the second target clock signal, the third target clock signal, and the fourth target clock signal have successive 90-degree phase shifts within an error allowable range. Subsequent related definitions regarding phase values, signal alignment, or signal waveform identity are all meant to be within the error allowable range.

In some embodiments, recording the phase sequence of the first phase clock signal ICLK and the third phase clock signal IBCLK at the SRX timing of the memory includes: receiving, by the memory, a no-operation NOP command at the SRX timing, and if the no-operation NOP command is sampled at a rising edge of the first phase clock signal ICLK, recording that the first phase clock signal ICLK leads the third phase clock signal IBCLK in phase; and if the no-operation NOP command is sampled at a rising edge of the third phase clock signal IBCLK, recording that the first phase clock signal ICLK lags the third phase clock signal IBCLK in phase. As can be seen from the foregoing, the memory exits the self-refresh mode in response to an SRX command, and then receives a NOP command. That is, the memory, when exiting the self-refresh mode, may receive the SRX and NOP commands in sequence. When the memory exits the self-refresh mode, the external clock signal is received again to generate four-phase clock signals to sample the received command. Based on this, by determining a specific phase clock signal whose rising edge samples the NOP command, it can be known which phase clock signal is generated first at the SRX timing, i.e., the phase sequence of the first phase clock signal ICLK and the third phase clock signal IBCLK can be known.

In some embodiments, comparing the phase sequence of the first phase clock signal ICLK and the third phase clock signal IBCLK at the SRX timing with the phase sequence of the first phase clock signal ICLK and the third phase clock signal IBCLK at the previous SRX timing, and outputting the determination result signal according to whether the two phase sequences are consistent or not include: outputting the determination result signal with a logic value of 1 if the two phase sequences are consistent, and outputting the determination result signal with the logic value of 0 if the two phase sequences are inconsistent. In this way, the determination result signal with the logic value of 0 or 1 is output according to whether the two phase sequences are consistent, such that the delay adjustment circuit 11 connected with the determination circuit can selectively adjust the delays of some phase clock signals in the four-phase clock signals according to the specific logic value of the determination result signal. In addition, according to different practical application requirements, it may also be set to output the determination result signal with the logic value of 0 if the two phase sequences are consistent, and output the determination result signal with the logic value of 1 if the two phase sequences are inconsistent.

In some embodiments, as shown in FIG. 4, the delay adjustment circuit 11 includes:
a control circuit 111, configured to receive a first set of control codes, a second set of control codes, and the determination result signal, output the first set of control codes as target control codes if the logic value of the determination result signal is 1, and output the second set of control codes as the target control codes if the logic value of the determination result signal is 0; where the first set of control codes is used for adjusting the delays of the second phase clock signal QCLK, the third phase clock signal IBCLK, and the fourth phase clock signal QBCLK, and the second set of control codes is used for adjusting the delays of the first phase clock signal ICLK, the second phase clock signal QCLK, and the fourth phase clock signal QBCLK; and
a delay circuit 112, electrically connected with the control circuit 111, and configured to receive the first phase clock signal ICLK, the second phase clock signal QCLK, the third phase clock signal IBCLK, the fourth phase clock signal QBCLK, and the target control codes, adjust the delays of the second phase clock signal QCLK, the third phase clock signal IBCLK, and the fourth phase clock signal QBCLK or adjust the delays of the first phase clock signal ICLK, the second phase clock signal QCLK, and the fourth phase clock signal QBCLK according to the target control codes, and output the first target clock signal ICLK_out, the second target clock signal QCLK_out, the third target clock signal IBCLK_out, and the fourth target clock signal QBCLK_out.

It can be understood that the delay circuit 112 adjusts the delays of some of the four-phase clock signals according to the target control codes, and therefore the target control codes need to be determined by the control circuit 111 according to the logic value of the determination result signal in advance. Therefore, during DCA training, the phase differences between the four-phase clock signals can be adjusted more quickly, the DCA training time is saved, and the accuracy of the four-phase clock signals is improved.

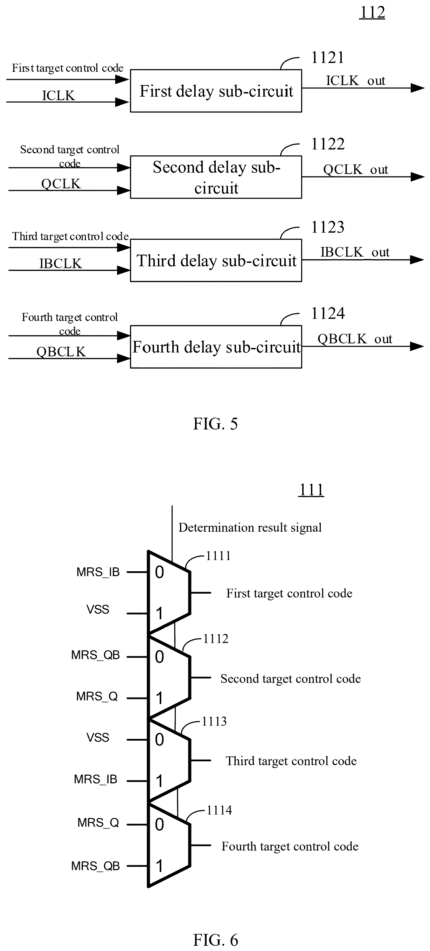

In some embodiments, as shown in FIG. 5, the target control codes include a first target control code, a second target control code, a third target control code, and a fourth target control code, and the delay circuit 112 includes: a first delay sub-circuit 1121, configured to receive the first phase clock signal ICLK and the first target control code, adjust the delay of the first phase clock signal ICLK according to the first target control code, and output the first target clock signal ICLK_out; a second delay sub-circuit 1122, configured to receive the second phase clock signal QCLK and the second target control code, adjust the delay of the second phase clock signal QCLK according to the second target control code, and output the second target clock signal QCLK_out; a third delay sub-circuit 1123, configured to receive the third phase clock signal IBCLK and the third target control code, adjust the delay of the third phase clock signal IBCLK according to the third target control code, and output the third target clock signal IBCLK_out; and a fourth delay sub-circuit 1124, configured to receive the fourth phase clock signal IBCLK and the fourth target control code, adjust the delay of the fourth phase clock signal IBCLK according to the fourth target control code, and output the fourth target clock signal IBCLK_out.

It should be noted that the first delay sub-circuit 1121, the second delay sub-circuit 1122, the third delay sub-circuit 1123, and the fourth delay sub-circuit 1124 are of the same structure, and the first target control code, the second target control code, the third target control code, and the fourth target control code can respectively control the delays of input signals of the respective delay sub-circuits, so as to finally obtain a set of target clock signals (i.e., ICLK_out, QCLK_out, IBCLK_out, and IBCLK_out) with each phase difference of 90 degrees.

In some embodiments, as shown in FIG. 6, the first set of control codes sequentially includes a ground signal VSS, a second phase control code MRS_Q, a third phase control code MRS_IB, and a fourth phase control code MRS_QB; the second set of control codes sequentially includes the third phase control code MRS_IB, the fourth phase control code MRS_QB, the ground signal VSS, and the second phase control code MRS_Q; and the control circuit 111 includes: a first selection unit 1111, configured to receive the ground signal VSS, the third phase control code MRS_IB, and the determination result signal, output the ground signal VSS as the first target control code if the logic value of the determination result signal is 1, and output the third phase control code MRS_IB as the first target control code if the logic value of the determination result signal is 0; a second selection unit 1112, configured to receive the second phase control code MRS_Q, the fourth phase control code MRS_QB, and the determination result signal, output the second phase control code MRS_Q as the second target control code if the logic value of the determination result signal is 1, and output the fourth phase control code MRS_QB as the second target control code if the logic value of the determination result signal is 0; a third selection unit 1113, configured to receive the third phase control code MRS_IB, the ground signal VSS, and the determination result signal, output the third phase control code MRS_IB as the third target control code if the logic value of the determination result signal is 1, and output the ground signal VSS as the third target control code if the logic value of the determination result signal is 0; and a fourth selection unit 1114, configured to receive the fourth phase control code MRS_QB, the second phase control code MRS_Q, and the determination result signal, output the fourth phase control code MRS_QB as the fourth target control code if the logic value of the determination result signal is 1, and output the second phase control code MRS_Q as the fourth target control code if the logic value of the determination result signal is 0.

It can be understood that if the logic value of the determination result signal is 1, that is, the phase sequence of the first phase clock signal ICLK and the third phase clock signal IBCLK at the current SRX timing and the phase sequence of the first phase clock signal ICLK and the third phase clock signal IBCLK at the previous SRX timing is consistent, the first target control code, the second target control code, the third target control code, and the fourth target control code output by the control circuit 111 are respectively VSS, MRS_Q, MRS_IB, and MRS_QB in sequence, and the delay circuit 112 respectively adjusts the delays of QCLK, IBCLK, and QBCLK in response to the target control codes. That is, the second delay sub-circuit 1122 adjusts the delay of QCLK in response to MRS_Q, the third delay sub-circuit 1123 adjusts the delay of IBCLK in response to MRS_IB, and the fourth delay sub-circuit 1124 adjusts the delay of QBCLK in response to MRS_QB. At this time, the first target control code received by the first delay sub-circuit 1121 is the ground signal VSS, so the input first phase clock signal ICLK does not need to be delayed, that is, the delay of ICLK is fixed. If the logic value of the determination result signal is 0, that is, the phase sequence of the first phase clock signal ICLK and the third phase clock signal IBCLK at the current SRX timing and the phase sequence of the first phase clock signal ICLK and the third phase clock signal IBCLK at the previous SRX timing is inconsistent, the first target control code, the second target control code, the third target control code, and the fourth target control code output by the control circuit 111 are respectively MRS_IB, MRS_QB, VSS, and MRS_Q in sequence, and the delay circuit 112 respectively adjusts the delays of ICLK, QCLK, and QBCLK in response to the target control codes. That is, the first delay sub-circuit 1121 adjusts the delay of ICLK in response to MRS_IB, the second delay sub-circuit 1122 adjusts the delay of QCLK in response to MRS_QB, and the fourth delay sub-circuit 1124 adjusts the delay of QBCLK in response to MRS_Q. At this time, the third target control code received by the third delay sub-circuit 1123 is the ground signal VSS, so the input third phase clock signal IBCLK does not need to be delayed, that is, the delay of IBCLK is fixed.

In this way, it is not necessary to change the specific values of the second phase control code MRS_Q, the third phase control code MRS_IB, and the fourth phase control code MRS_QB, and it is only necessary for the control circuit 111 to select the first set of control codes or the second set of control codes as the target control codes according to the determination result signal, that is, which phase clock signals are specifically controlled by the second phase control code MRS_Q, the third phase control code MRS_IB, and the fourth phase control code MRS_QB, so as to switch the delay control of the four-phase clock signals, such that under the condition that the sequence of the four-phase clock signals generated when the memory exits the self-refresh mode changes, the phase differences between the four-phase clock signals can be quickly and accurately adjusted by using the above parameters set in the mode register last time in the subsequent DCA training mode.

In some embodiments, the second phase control code MRS_Q, the third phase control code MRS_IB, and the fourth phase control code MRS_QB are stored and output by a mode register. In the DCA training mode, the delays of the four-phase clock signals are adjusted by setting parameters of a mode register to adjust the phase differences between the internal four-phase clock signals, such that the difference between each of the phase differences and 90 degrees is less than a preset value, i.e., the phase differences between the internal four-phase clock signals approach 90 degrees.

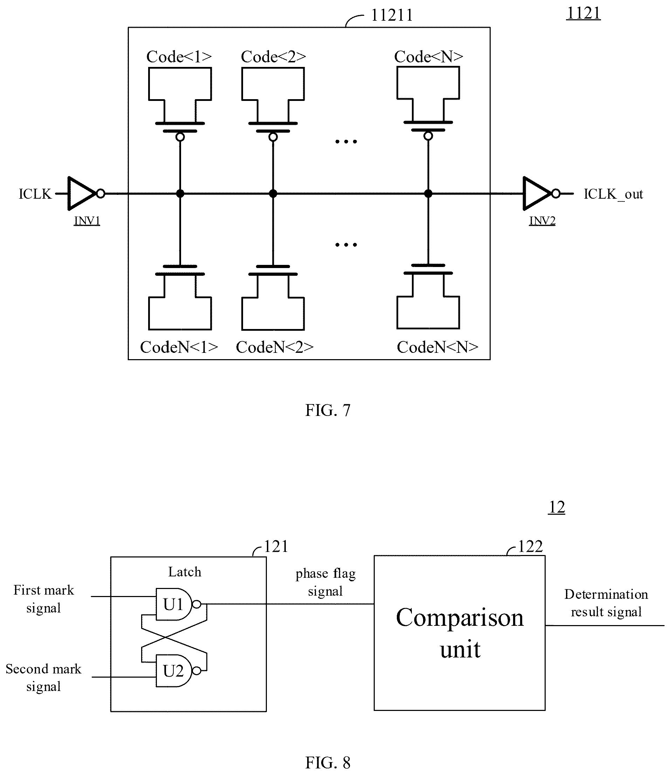

In some embodiments, as shown in FIG. 7, the first delay sub-circuit 1121 includes a first capacitor unit 11211 and an even number of first inverters, where the even number of first inverters are sequentially connected, an input terminal of a first inverter at the head receives the first phase clock signal ICLK, an output terminal of a first inverter at the tail outputs the first target clock signal ICLK_out, and the first capacitor unit 11211 receives the first target control code and is connected to an output terminal of one of the first inverters; the second delay sub-circuit includes a second capacitor unit and an even number of second inverters, where the even number of second inverters are sequentially connected, an input terminal of a second inverter at the head receives the second phase clock signal QCLK, an output terminal of a second inverter at the tail outputs the second target clock signal QCLK_out, and the second capacitor unit receives the second target control code and is connected to an output terminal of one of the second inverters; the third delay sub-circuit includes a third capacitor unit and an even number of third inverters, where the even number of third inverters are sequentially connected, an input terminal of a third inverter at the head receives the third phase clock signal IBCLK, an output terminal of a third inverter at the tail outputs the third target clock signal IBCLK_out, and the third capacitor unit receives the third target control code and is connected to an output terminal of one of the third inverters; and the fourth delay sub-circuit includes a fourth capacitor unit and an even number of fourth inverters, where the even number of fourth inverters are sequentially connected, an input terminal of a fourth inverter at the head receives the fourth phase clock signal QBCLK, an output terminal of a fourth inverter at the tail outputs the fourth target clock signal QBCLK_out, and the fourth capacitor unit receives the fourth target control code and is connected to an output terminal of one of the fourth inverters.

It should be noted that the first delay sub-circuit 1121, the second delay sub-circuit 1122, the third delay sub-circuit 1123, and the fourth delay sub-circuit 1124 are of the same structure, and here, the first delay sub-circuit 1121 is exemplified. In FIG. 7, the first delay sub-circuit 1121 includes two first inverters INV1 and INV2, an input terminal of the first inverter INV1 at the head receives the first phase clock signal ICLK, an output terminal of INV1 is connected to an input terminal of the first inverter INV2 at the tail, an output terminal of INV2 outputs the first target clock signal ICLK_out, and the first capacitor unit 11211 is connected to the output terminal of INV1 for adjusting the delay on the transmission path. It can be understood that, in other embodiments, the number of the first inverters may also be an even number such as 4, 6, or 8, and the first capacitor unit may also be connected to an output terminal of any one of the first inverters to adjust the delay on the transmission path.

The first capacitor unit 11211 is composed of MOS capacitors, and as shown in FIG. 7, includes N PMOS and N NMOS, all of whose gates are connected together and to an output terminal of one of the first inverters. The first target control code includes Code<N:1> and CodeN<N:1>, a source and a drain of each PMOS are connected and receive one bit of the first target control code Code<N:1>, and a source and a drain of each NMOS are connected and receive one bit of the first target control code CodeN<N:1>. Where, each corresponding bit in Code<N:1> and CodeN<N:1> is phase-inverted, for example, Code<i> and CodeN<i> are mutually inverted, where i is less than or equal to N, and i is greater than or equal to 1. Thus, the equivalent capacitance values of a pair of PMOS and NMOS receiving Code<i> and CodeN<i> are controlled by Code<i> and CodeN<i>. Thus, the equivalent capacitance value of the first capacitor unit 11211 can be adjusted by adjusting the first target control code, so as to adjust the delay of the first delay sub-circuit 1121. Since the initial value of the first target control code is all zeros, when the determination result signal is 1 and the first target control code is the ground signal VSS, the initial value of the first target control code is maintained, and the delay of the first delay sub-circuit 1121 is not adjusted. When the determination result signal is 0 and the first target control code is MRS_IB, the first delay sub-circuit 1121 adjusts the delay of ICLK in response to MRS_IB.

In addition, the first capacitor unit 11211 may be formed of other capacitor structures with adjustable capacitance values according to different practical application requirements.

In some embodiments, as shown in FIG. 8, the determination circuit 12 includes: a latch 121, configured to receive a first mark signal and a second mark signal, where the first mark signal is used for indicating that the no-operation NOP command is sampled at the rising edge of the first phase clock signal ICLK at the SRX timing, the second mark signal is used for indicating that the no-operation NOP command is sampled at the rising edge of the third phase clock signal IBCLK at the SRX timing, and output a phase flag signal at a first level if the first mark signal is in a valid state and output the phase flag signal at a second level if the second mark signal is in the valid state; and a comparison unit 122, electrically connected with the latch 121, and configured to receive and store the phase flag signal, compare a level state of the phase flag signal received at current SRX timing with a level state of the phase flag signal received at previous SRX timing, output the determination result signal with the logic value of 1 if the two level states are consistent, and output the determination result signal with the logic value of 0 if the two level states are inconsistent.

For example, at the SRX timing, the no-operation NOP command received by the memory is sampled at the rising edge of the first phase clock signal ICLK, then the first mark signal is in a valid state, e.g., at a low level, and the latch 121 outputs the phase flag signal at the first level, which indicates that the first phase clock signal ICLK leads the third phase clock signal IBCLK in phase; and at the SRX timing, the no-operation NOP command received by the memory is sampled at the rising edge of the third phase clock signal IBCLK, then the second mark signal is in a valid state, e.g., at a low level, and the latch 121 outputs the phase flag signal at the second level, which indicates that the first phase clock signal ICLK lags the third phase clock signal IBCLK in phase. The comparison unit 122 stores and compares the currently received phase flag signal with the previously received phase flag signal, and by comparing the level states of the two received phase flag signals, it can be known whether the phase sequence of the first phase clock signal ICLK and the third phase clock signal IBCLK at the current SRX timing and the phase sequence of the first phase clock signal ICLK and the third phase clock signal IBCLK at the previous SRX timing are consistent, so as to output the determination result signal.

In some embodiments, the latch is an SR latch, a first terminal of the SR latch receives the first mark signal, a second terminal receives the second mark signal, and an output terminal outputs the phase flag signal. When the first mark signal is at a low level, the phase mark signal output by the SR latch is at a high level, and when the second mark signal is at a low level, the phase mark signal output by the SR latch is at a low level. At this time, the first level is a high level, and the second level is a low level.

In summary, for a high-speed memory, the embodiments of the present disclosure provide a clock control circuit 10, which includes: a delay adjustment circuit 11, configured to receive a first phase clock signal ICLK, a second phase clock signal QCLK, a third phase clock signal IBCLK, a fourth phase clock signal QBCLK, and a determination result signal, adjust delays of the second phase clock signal QCLK, the third phase clock signal IBCLK, and the fourth phase clock signal QBCLK or adjust delays of the first phase clock signal ICLK, the second phase clock signal QCLK, and the fourth phase clock signal QBCLK according to the determination result signal when the memory is in a DCA training mode, and output a first target clock signal ICLK_out, a second target clock signal QCLK_out, a third target clock signal IBCLK_out, and a fourth target clock signal QBCLK_out; and a determination circuit 12, electrically connected with the delay adjustment circuit 11, and configured to record a phase sequence of the first phase clock signal ICLK and the third phase clock signal IBCLK at SRX timing of the memory, then compare the phase sequence of the first phase clock signal ICLK and the third phase clock signal IBCLK at the SRX timing with a phase sequence of the first phase clock signal ICLK and the third phase clock signal IBCLK at previous SRX timing, and output the determination result signal according to whether the two phase sequences are consistent. When the memory is in the self-refresh mode, an external clock signal is not received, and when the memory exits the self-refresh mode, the external clock signal is received again, and at the moment, duty cycle adjust training needs to be carried out to adjust the phase difference between the internal four-phase clock signals. The phase sequence of the first phase clock signal and the third phase clock signal at the current self-refresh exit timing and the phase sequence of the first phase clock signal and the third phase clock signal at the previous self-refresh exit timing are recorded and compared, and the delays of the second phase clock signal, the third phase clock signal, and the fourth phase clock signal or the delays of the first phase clock signal, the second phase clock signal, and the fourth phase clock signal are adjusted according to whether the two phase sequences are consistent or not, which is favorable for adjusting the phase differences between the four-phase clock signals more accurately and more quickly in a duty cycle adjustment training mode, saving the time of duty cycle adjust training, improving the accuracy of the four-phase clock signals, and ensuring the quality of final output data of the memory.

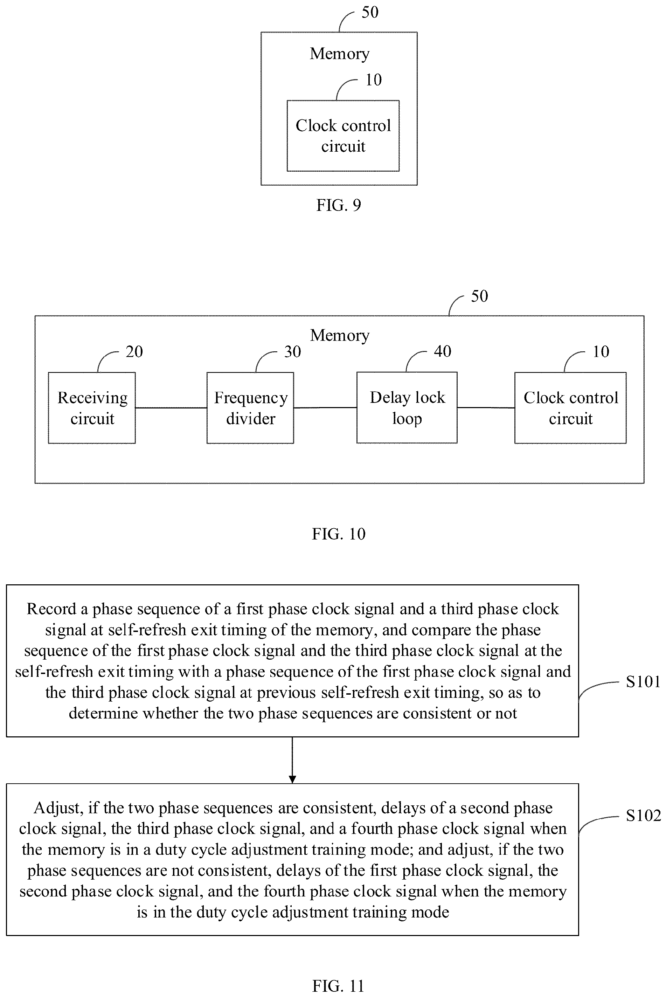

In yet another embodiment of the present disclosure, referring to FIG. 9, a schematic diagram of a composition structure of a memory 50 according to an embodiment of the present disclosure is illustrated. As shown in FIG. 9, the memory 50 includes at least the aforementioned clock control circuit 10.

In some embodiments, the memory conforms to at least one of the following specifications: DDR3 specification, DDR4 specification, DDR5 specification, DDR6 specification, LPDDR3 specification, LPDDR4 specification, LPDDR5 specification, and LPDDR6 specification.

In some embodiments, as shown in FIG. 10, the memory 50 further includes: a receiving circuit 20, configured to receive an external clock signal CKT and output an internal clock signal, the internal clock signal having a same frequency as the external clock signal; a frequency divider 30, electrically connected with the receiving circuit 20, and configured to receive the internal clock signal, divide the internal clock signal by two, and generate the first phase clock signal ICLK, the second phase clock signal QCLK, the third phase clock signal IBCLK, and the fourth phase clock signal QBCLK; and a delay lock loop 40, electrically connected with the frequency divider 30 and the clock control circuit 10, and configured to delay at least one of the first phase clock signal ICLK, the second phase clock signal QCLK, the third phase clock signal IBCLK, and the fourth phase clock signal QBCLK such that the at least one of the first phase clock signal ICLK, the second phase clock signal QCLK, the third phase clock signal IBCLK, and the fourth phase clock signal QBCLK has a phase difference with the external clock signal CKT that is less than a preset value.

The frequencies of the first phase clock signal ICLK, the second phase clock signal QCLK, the third phase clock signal IBCLK, and the fourth phase clock signal QBCLK generated by the frequency divider 30 are half of the frequency of the external clock signal CKT. Ideally, ICLK, QCLK, IBCLK, and QBCLK should have successive 90-degree phase shifts. However, in a high-frequency environment, the duty cycle of an external clock signal CKT received by the memory is unstable, and the phase differences between four-phase clock signals output by a frequency divider deviate significantly from the ideal 90-degree spacing. In the DCA training mode, the clock control circuit 10 adjusts the phase differences between the four-phase clock signals such that the difference between each of the phase differences and 90 degrees is less than a preset value, i.e., the phase differences between the internal four-phase clock signals approach 90 degrees. A delay lock loop (DLL) 40 is configured to synchronize the internal clock signal with the external clock signal CKT such that a rising edge of at least one of ICLK, QCLK, IBCLK, and QBCLK is aligned with a rising edge of the external clock signal CKT within an error allowable range, i.e., the phase difference between the external clock signal CKT and the at least one of ICLK, QCLK, IBCLK, and QBCLK is less than a preset value. In this way, the quality of the output data of the memory can be ensured.

In the embodiments of the present disclosure, for the memory 50, when the memory is in the self-refresh mode, an external clock signal is not received, and when the memory exits the self-refresh mode, the external clock signal is received again, and at the moment, DCA training needs to be carried out to adjust the phase differences between the internal four-phase clock signals. The phase sequence of the first phase clock signal and the third phase clock signal at the current self-refresh exit timing and the phase sequence of the first phase clock signal and the third phase clock signal at the previous self-refresh exit timing are recorded and compared, and the delays of the second phase clock signal, the third phase clock signal, and the fourth phase clock signal or the delays of the first phase clock signal, the second phase clock signal, and the fourth phase clock signal are adjusted according to whether the two phase sequences are consistent or not, which is favorable for adjusting the phase differences between the four-phase clock signals more accurately and more quickly in a duty cycle adjustment training mode, saving the time of duty cycle adjust training, improving the accuracy of the four-phase clock signals, and ensuring the quality of final output data of the memory.

In yet another embodiment of the present disclosure, referring to FIG. 11, a schematic flowchart of a clock control method according to an embodiment of the present disclosure is illustrated. As shown in FIG. 11, the method may include:
S101, recording a phase sequence of a first phase clock signal and a third phase clock signal at SRX timing of the memory, and comparing the phase sequence of the first phase clock signal and the third phase clock signal at the SRX timing with a phase sequence of the first phase clock signal and the third phase clock signal at previous SRX timing, so as to determine whether the two phase sequences are consistent or not; and
S102, adjusting, if the two phase sequences are consistent, delays of a second phase clock signal, the third phase clock signal, and a fourth phase clock signal when the memory is in a DCA training mode; and adjusting, if the two phase sequences are not consistent, delays of the first phase clock signal, the second phase clock signal, and the fourth phase clock signal when the memory is in the DCA training mode.

In some embodiments, the method specifically includes: receiving, by the memory, a no-operation NOP command at the SRX timing, and if the no-operation NOP command is sampled at a rising edge of the first phase clock signal, recording that the first phase clock signal leads the third phase clock signal in phase; and if the no-operation NOP command is sampled at a rising edge of the third phase clock signal, recording that the first phase clock signal lags the third phase clock signal in phase.

In some embodiments, if the two phase sequences are consistent, the delays of the second phase clock signal, the third phase clock signal, and the fourth phase clock signal are adjusted by using a first set of control codes when the memory is in the DCA training mode; and if the two phase sequences are not consistent, the delays of the first phase clock signal, the second phase clock signal, and the fourth phase clock signal are adjusted by using a second set of control codes when the memory is in the DCA training mode.

In the clock control method according to the embodiments of the present disclosure, the phase sequence of the first phase clock signal and the third phase clock signal at the current SRX timing and the phase sequence of the first phase clock signal and the third phase clock signal at the previous SRX timing are recorded and compared, and the delays of the second phase clock signal, the third phase clock signal, and the fourth phase clock signal or the delays of the first phase clock signal, the second phase clock signal, and the fourth phase clock signal are adjusted according to whether the two phase sequences are consistent or not, which is favorable for adjusting the phase differences between the four-phase clock signals more accurately and more quickly in a DCA training mode, saving the DCA training time, improving the accuracy of the four-phase clock signals, and ensuring the quality of final output data of the memory.

The foregoing description shows merely preferred embodiments of the present disclosure and is not intended to limit the protection scope of the present disclosure. It should be noted that in the present disclosure, the terms "include", "comprise", or any other variants thereof are intended to cover non-exclusive inclusion, such that a process, a method, an item, or an apparatus including a series of elements includes not only those elements but also other elements not explicitly listed, or elements inherent to such process, method, item, or apparatus. Without further limitation, an element defined by the phrase "including a..." does not exclude the presence of additional identical elements in the process, method, item, or apparatus that includes the element. The serial numbers of the embodiments of the present disclosure described above are for the purpose of describing only and do not represent the superiority or inferiority of the embodiments. The methods disclosed in the method embodiments provided in the present disclosure may be combined in any manner without conflict to obtain new method embodiments. The features disclosed in the product embodiments provided in the present disclosure may be combined in any manner without conflict to obtain new product embodiments. The features disclosed in the method or device embodiments provided in the present disclosure may be combined in any manner without conflict to obtain new method or device embodiments. The foregoing description is merely the specific embodiments of the present disclosure, but the protection scope of the present disclosure is not limited thereto; and changes or substitutions that any one skilled in the art can easily think of within the technical scope disclosed by the present disclosure shall all fall within the protection scope of the present disclosure. Therefore, the protection scope of the present disclosure shall be defined by the protection scope of the claims.

## Claims

1. A clock control circuit (10), applied to a memory (50), comprising:
a delay adjustment circuit (11), configured to receive a first phase clock signal, a second phase clock signal, a third phase clock signal, a fourth phase clock signal, and a determination result signal, adjust delays of the second phase clock signal, the third phase clock signal, and the fourth phase clock signal or adjust delays of the first phase clock signal, the second phase clock signal, and the fourth phase clock signal according to the determination result signal when the memory is in a duty cycle adjustment training mode, and output a first target clock signal, a second target clock signal, a third target clock signal, and a fourth target clock signal; and
a determination circuit (12), electrically connected with the delay adjustment circuit, and configured to record a phase sequence of the first phase clock signal and the third phase clock signal at self-refresh exit timing of the memory, then compare the phase sequence of the first phase clock signal and the third phase clock signal at the self-refresh exit timing with a phase sequence of the first phase clock signal and the third phase clock signal at previous self-refresh exit timing, and output the determination result signal according to whether the two phase sequences are consistent or not.

2. The clock control circuit according to claim 1, wherein recording the phase sequence of the first phase clock signal and the third phase clock signal at the self-refresh exit timing of the memory comprises:
receiving, by the memory, a no-operation NOP command at the self-refresh exit timing, and if the no-operation NOP command is sampled at a rising edge of the first phase clock signal, recording that the first phase clock signal leads the third phase clock signal in phase; and if the no-operation NOP command is sampled at a rising edge of the third phase clock signal, recording that the first phase clock signal lags the third phase clock signal in phase; and
comparing the phase sequence of the first phase clock signal and the third phase clock signal at the self-refresh exit timing with the phase sequence of the first phase clock signal and the third phase clock signal at the previous self-refresh exit timing, and outputting the determination result signal according to whether the two phase sequences are consistent or not comprise:
outputting the determination result signal with a logic value of 1 if the two phase sequences are consistent, and outputting the determination result signal with the logic value of 0 if the two phase sequences are inconsistent.

3. The clock control circuit according to claim 2, wherein the delay adjustment circuit comprises:
a control circuit (111), configured to receive a first set of control codes, a second set of control codes, and the determination result signal, output the first set of control codes as target control codes if the logic value of the determination result signal is 1, and output the second set of control codes as the target control codes if the logic value of the determination result signal is 0; wherein the first set of control codes is used for adjusting the delays of the second phase clock signal, the third phase clock signal, and the fourth phase clock signal, and the second set of control codes is used for adjusting the delays of the first phase clock signal, the second phase clock signal, and the fourth phase clock signal; and
a delay circuit (112), electrically connected with the control circuit, and configured to receive the first phase clock signal, the second phase clock signal, the third phase clock signal, the fourth phase clock signal and the target control codes, adjust the delays of the second phase clock signal, the third phase clock signal, and the fourth phase clock signal or adjust the delays of the first phase clock signal, the second phase clock signal, and the fourth phase clock signal according to the target control codes, and output the first target clock signal, the second target clock signal, the third target clock signal, and the fourth target clock signal.

4. The clock control circuit according to claim 3, wherein the target control codes comprise a first target control code, a second target control code, a third target control code, and a fourth target control code, and the delay circuit comprises:
a first delay sub-circuit (1121), configured to receive the first phase clock signal and the first target control code, adjust the delay of the first phase clock signal according to the first target control code, and output the first target clock signal;
a second delay sub-circuit (1122), configured to receive the second phase clock signal and the second target control code, adjust the delay of the second phase clock signal according to the second target control code, and output the second target clock signal;
a third delay sub-circuit (1123), configured to receive the third phase clock signal and the third target control code, adjust the delay of the third phase clock signal according to the third target control code, and output the third target clock signal; and
a fourth delay sub-circuit (1124), configured to receive the fourth phase clock signal and the fourth target control code, adjust the delay of the fourth phase clock signal according to the fourth target control code, and output the fourth target clock signal.

5. The clock control circuit according to claim 4, wherein the first set of control codes sequentially comprises a ground signal, a second phase control code, a third phase control code, and a fourth phase control code; the second set of control codes sequentially comprises the third phase control code, the fourth phase control code, the ground signal, and the second phase control code; and the control circuit comprises:
a first selection unit (1111), configured to receive the ground signal, the third phase control code, and the determination result signal, output the ground signal as the first target control code if the logic value of the determination result signal is 1, and output the third phase control code as the first target control code if the logic value of the determination result signal is 0;
a second selection unit (1112), configured to receive the second phase control code, the fourth phase control code, and the determination result signal, output the second phase control code as the second target control code if the logic value of the determination result signal is 1, and output the fourth phase control code as the second target control code if the logic value of the determination result signal is 0;
a third selection unit (1113), configured to receive the third phase control code, the ground signal, and the determination result signal, output the third phase control code as the third target control code if the logic value of the determination result signal is 1, and output the ground signal as the third target control code if the logic value of the determination result signal is 0; and
a fourth selection unit (1114), configured to receive the fourth phase control code, the second phase control code, and the determination result signal, output the fourth phase control code as the fourth target control code if the logic value of the determination result signal is 1, and output the second phase control code as the fourth target control code if the logic value of the determination result signal is 0.

6. The clock control circuit according to claim 5, wherein the second phase control code, the third phase control code, and the fourth phase control code are stored and output by a mode register.

7. The clock control circuit according to claim 4, wherein
the first delay sub-circuit comprises a first capacitor unit and an even number of first inverters, wherein the even number of first inverters are sequentially connected, an input terminal of a first inverter at a head receives the first phase clock signal, an output terminal of a first inverter at a tail outputs the first target clock signal, and the first capacitor unit receives the first target control code and is connected to an output terminal of one of the first inverters;
the second delay sub-circuit comprises a second capacitor unit and an even number of second inverters, wherein the even number of second inverters are sequentially connected, an input terminal of a second inverter at a head receives the second phase clock signal, an output terminal of a second inverter at a tail outputs the second target clock signal, and the second capacitor unit receives the second target control code and is connected to an output terminal of one of the second inverters;
the third delay sub-circuit comprises a third capacitor unit and an even number of third inverters, wherein the even number of third inverters are sequentially connected, an input terminal of a third inverter at a head receives the third phase clock signal, an output terminal of a third inverter at a tail outputs the third target clock signal, and the third capacitor unit receives the third target control code and is connected to an output terminal of one of the third inverters; and
the fourth delay sub-circuit comprises a fourth capacitor unit and an even number of fourth inverters, wherein the even number of fourth inverters are sequentially connected, an input terminal of a fourth inverter at a head receives the fourth phase clock signal, an output terminal of a fourth inverter at a tail outputs the fourth target clock signal, and the fourth capacitor unit receives the fourth target control code and is connected to an output terminal of one of the fourth inverters.

8. The clock control circuit according to claim 2, wherein the determination circuit comprises:
a latch (121), configured to receive a first mark signal and a second mark signal, wherein the first mark signal is used for indicating that the no-operation NOP command is sampled at the rising edge of the first phase clock signal at the self-refresh exit timing, the second mark signal is used for indicating that the no-operation NOP command is sampled at the rising edge of the third phase clock signal at the self-refresh exit timing, and output a phase flag signal at a first level if the first mark signal is in a valid state and output the phase flag signal at a second level if the second mark signal is in the valid state; and
a comparison unit (122), electrically connected with the latch, and configured to receive and store the phase flag signal, compare a level state of the phase flag signal received at current self-refresh exit timing with a level state of the phase flag signal received at previous self-refresh exit timing, output the determination result signal with the logic value of 1 if the two level states are consistent, and output the determination result signal with the logic value of 0 if the two level states are inconsistent.

9. The clock control circuit according to claim 8, wherein the latch is an SR latch, wherein a first terminal of the SR latch receives the first mark signal, a second terminal receives the second mark signal, and an output terminal outputs the phase flag signal.

10. A memory (50), comprising the clock control circuit according to any one of claims 1 to 9.

11. The memory according to claim 10, further comprising:
a receiving circuit (20), configured to receive an external clock signal and output an internal clock signal, the internal clock signal having a same frequency as the external clock signal;
a frequency divider (30), electrically connected with the receiving circuit, and configured to receive the internal clock signal, divide the internal clock signal by two, and generate the first phase clock signal, the second phase clock signal, the third phase clock signal, and the fourth phase clock signal; and
a delay lock loop (40), electrically connected with the frequency divider and the clock control circuit, and configured to delay at least one of the first phase clock signal, the second phase clock signal, the third phase clock signal, and the fourth phase clock signal such that at least one of the first phase clock signal, the second phase clock signal, the third phase clock signal, and the fourth phase clock signal has a phase difference with the external clock signal that is less than a preset value.

12. The memory according to claim 11, wherein the memory conforms to DDR5 specification.

13. A clock control method, applied to a memory and comprising:
recording a phase sequence of a first phase clock signal and a third phase clock signal at self-refresh exit timing of the memory, and comparing the phase sequence of the first phase clock signal and the third phase clock signal at the self-refresh exit timing with a phase sequence of the first phase clock signal and the third phase clock signal at previous self-refresh exit timing, so as to determine whether the two phase sequences are consistent or not (S101); and
adjusting, if the two phase sequences are consistent, delays of a second phase clock signal, the third phase clock signal, and a fourth phase clock signal when the memory is in a duty cycle adjustment training mode; and adjusting, if the two phase sequences are not consistent, delays of the first phase clock signal, the second phase clock signal, and the fourth phase clock signal when the memory is in the duty cycle adjustment training mode (S102).

14. The clock control method according to claim 13, wherein recording the phase sequence of the first phase clock signal and the third phase clock signal at the self-refresh exit timing of the memory comprises:
receiving, by the memory, a no-operation NOP command at the self-refresh exit timing, and if the no-operation NOP command is sampled at a rising edge of the first phase clock signal, recording that the first phase clock signal leads the third phase clock signal in phase; and if the no-operation NOP command is sampled at a rising edge of the third phase clock signal, recording that the first phase clock signal lags the third phase clock signal in phase.

15. The clock control method according to claim 13, wherein adjusting, if the two phase sequences are consistent, the delays of the second phase clock signal, the third phase clock signal, and the fourth phase clock signal when the memory is in the duty cycle adjustment training mode; and adjusting, if the two phase sequences are not consistent, the delays of the first phase clock signal, the second phase clock signal, and the fourth phase clock signal when the memory is in the duty cycle adjustment training mode comprise:
adjusting, if the two phase sequences are consistent, the delays of the second phase clock signal, the third phase clock signal, and the fourth phase clock signal by using a first set of control codes when the memory is in the duty cycle adjustment training mode; and adjusting, if the two phase sequences are not consistent, the delays of the first phase clock signal, the second phase clock signal, and the fourth phase clock signal by using a second set of control codes when the memory is in the duty cycle adjustment training mode.
